# EUROPÄISCHE PATENTANMELDUNG

(11) **EP 0 770 924 A2**
(43) Veröffentlichungstag der Anmeldung: **02.05.1997**
(21) Anmeldenummer: 96116472.0
(22) Anmeldetag: 15.10.1996
(51) Int. Cl.: G03F 7/039

(54) **Verfahren zur Mikrostrukturierung von Polymeren**

(30) Priorität: 27.10.1995 DE 19540074
(71) Anmelder: BAYER AG, 51368 Leverkusen (DE)
(72) Erfinder: Stebani, Jürgen, Dr., 47800 Krefeld (DE); Wokaun, Alexander, Prof. Dr., 5304 Endingen (CH); Lippert, Thomas, Dr., Los Alamos, New Mexico 87544 (US); Kunz, Thilo, 8347 Zurzach (CH)

(57) **Zusammenfassung**

Die Erfindung betrifft ein Verfahren zur Erzeugung von Mikrostrukturen in polymeren Substraten durch Bestrahlung mit Licht einer Wellenlänge im Bereich von 260-360 nm unter Abbau des polymeren Substrates im bestrahlten Bereich, wobei das Polymere mindestens 5 Mol-% Struktureinheiten der Formel I aufweist.

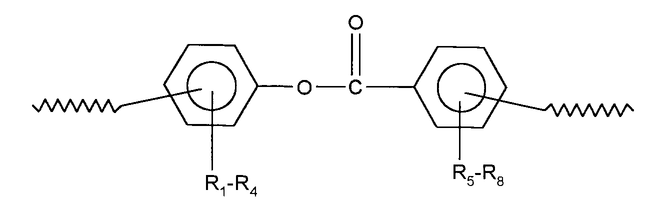

## Beschreibung

Die Erfindung bezieht sieh auf ein Verfahren zur Erzeugung von definierten Mikrostrukturen in Polymeroberflächen mit Hilfe einer UV-Licht einer Wellenlänge im Bereich von 260 - 360 nm emittierenden Lichtquelle, insbesondere eines Lasers. Die Mikrostrukturierung von organischen Polymeren ist für eine Reihe von Anwendungen auf den Gebieten der Elektronik, der Leiterplatten-, Multilayer-, und Halbleitertechnik, der Optoelektronik der Mikromechanik und der Mikrosystemtechnik von großer Bedeutung. Die mikrostrukturierten Polymeren können eingesetzt werden in Anwendungen wie der Mikromechanik und der Mikrooptik, z.B. für Mikrolinsen, Mikrogittern oder -Prismen zur Herstellung von Mikrosystemen wie Mikrokameras oder Mikrospektrometern, oder zur optischen Datenverarbeitung.

Besonders interessant sind, im Falle der Mikroelektronik, Materialien, in denen sich vor allem sehr feine Strukturen abbilden lassen. Bei der Mikromechanik werden sehr resistente, hochwärmeformbeständige Polymere benötigt. Bei der Herstellung mikrooptischer Bauteile ist dagegen die Transparenz der Polymeren von Bedeutung. Zur Erzeugung von Strukturen in der Polymeroberfläche macht man sich die Wechselwirkung verschiedener Polymerbausteine mit elektromagnetischer Strahlung (meist UV-Licht) zunutze.

Die konventionelle Technik geht dabei von lichtempfindlichen Polymersystemen (Photoresists) aus, die nach dem sogenannten Positiv-Verfahren arbeiten. Dabei wird eine photosensible Polymerschicht über eine Maske mit UV-Licht bestrahlt, meist aus einer Quecksilberdampf-Lampe, wobei durch photochemische Reaktionen die bestrahlten Bereiche der Photoresistschicht ihre Konsistenz verändern, so daß in einem nachfolgenden naßchemischen Entwicklungsschritt diese Bereiche selektiv herausgelöst werden können. In jüngster Zeit wurden demgegenüber alternative Verfahren beschrieben (vgl. R. Srinivasan et. al., Appl. Phys. Lett. 41, S. 576, (1982)), bei denen die photochemischen Reaktionen in den belichteten Bereichen der polymeren Substrate durch Bestrahlung mit Laser-Lichtquellen ausgelöst werden. Dazu werden spezielle UV-Laser verwendet, sogenannte Excimer-Laser, die je nach Gasfüllung (Edelgas/Halogen), Wellenlängen von z.B. 193 nm (Argon/Fluor-Füllung), 248 nm (Krypton/Fluor), 308 nm (Xenon/HCl) bis 351 nm (Xenon/Fluor) emittieren können. Die abgestrahlte Laserenergie kann dabei so hoch sein, daß die Polymerketten zu niedermolekularen Bruchstücken abgebaut und aus der Polymeroberfläche entfernt werden, so daß eine direkte Strukturierung des Polymeren erfolgt. Diese Strukturierungstechnik wird auch als Laser-Ablation bezeichnet.

Die Ablation von Polycarbonat oder auch von Polyethylenterephthalat ist z.B. in einem Verfahren zur Herstellung eines planaren optischen Kopplers beschrieben worden, bei dem mit einem Excimer-Laser Wellenleiter-Kanäle mit geringen Oberflächenrauhigkeiten und hohen Maßgenauigkeiten in die Kunststoffe gefräst wurden (siehe z.B. EP-402,797). Zur Ablation von Polycarbonat (PC) oder Polyethylenterephthalat (PET) wurde dabei ein KrF-Laser verwendet mit einer Lichtwellenlänge von 248 nm, ebenso bei der Strukturierung von Blends aus Polytetrafluorethylen und einem aromatischen Polyester (Polym. Mater. Sci. Eng. 68, 165 (1993)). Der Einsatz des KrF-Excimer Lasers zur Mikrostrukturierung von aliphatischen Polyestern und/oder aliphatischen Polycarbonaten ist zudem in WO-9222336 beschrieben worden. Des weiteren sind Verfahren bekannt, bei denen zur Strukturierung von Polyethylenterephthalat oder Polycarbonat ein ArF-Excimer Laser mit einer Emissionswellenlänge von 193 nm verwendet wird (J. Appl. Phys. 63(6), 2110 (1988)). In zahlreichen wissenschaftlichen Untersuchungen wurde über die Ablatierbarkeit von Polyestern, speziell PET, und PC mit Excimer-Lasern berichtet. So wird die Abtragung von Polymermaterial aus einer PET-Oberfläche mittels ArF- (193 nm), KrF- (248 nm) und XeCl-Lasern (308 nm) beschrieben, wohingegen PC, aufgrund seiner fehlenden Lichtabsorption bei 308 nm, nur mit ArF- und KrF-Excimerlasern definiert bearbeitbar ist (Lazare et. al. in Excimer lasers 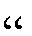 , L. D. Laude (ed.), Kluwer Academic Publishers, Amsterdam, 1994; Srinivasan et. al., J. Polym. Sci., Polym. Chem. Ed., 22, (1984), 2601-09). Ein Beispiel für den Einsatz von KrF-Lasern zur Ablation von PC wird z. B. in McGovern et. al., Chem Phys. Lett. 220, (1994), 177-180 gegeben. Die Bearbeitung von PET mit XeCl-Excimerlasern ist zwar möglich, jedoch wird aufgrund von photothermischen Prozessen im Polymeren das Material aufgeschmolzen, so daß ein Einsatz des XeCl-Lasers für Anwendungen von PET in der Mikrosystemtechnik ungeeignet ist (P. E. Dyer in Photochemical Processing of Electronic Materials 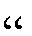 , I. W. Boyd, R. B. Jackman (eds.), Academic Press, London, 1991).

Die Nachteile der beiden zur Ablation von Polyestern und Polycarbonaten geeigneten Lasertypen (KrF-, ArF-Excimer), die bislang eine großtechnische Nutzung in industriellen Verfahren verhinderten, bestehen zum einen in der Verwendung einer Gasfüllung mit dem hochreaktiven, korrosiven Fluor-Gas, das eine aufwendige Technik mit weitreichenden Sicherheitsvorkehrungen erfordert und zum anderen in der relativ geringen Stabilität der Laser, was in der Praxis ein häufiges Austauschen der Gasfüllung des Lasers bedingt. Demgegenüber wäre die Verwendung des XeCl-Excimer Lasers wesentlich weniger technisch aufwendig und weniger sicherheitsrelevant. Bei Benutzung dieses stabileren, kostengünstigeren und damit für die industrielle Anwendung interessanteren XeCl-Excimer-Lasers (Gasfüllung Xe/HCl), der zudem bei einer höheren Energiedichte emittieren kann als der KrF-Laser, wird experimentell aber nur eine Carbonisierung der Polymeroberfläche bei Polycarbonaten, bzw. eine thermische Veränderung des Polymeren (Aufschmelzen) bei Polyethylenterephthalat beobachtet. Eine definierte Strukturierung dieser Substrate, die keine oder nur eine geringe Lichtabsorption bei 308 nm zeigen, ist nur bei Verwendung einer kürzeren Wellenlänge möglich.

Die Strukturierung von polymeren Substraten mit dem XeCl-Excimer Laser wird jedoch bereits großtechnisch bei der Behandlung von Polyimid-Folien eingesetzt, da Polyimide im Bereich von 308 nm Licht absorbieren. Dabei sind jedoch technische Maßnahmen notwendig, um zu verhindern, daß die entstandenen Polymerbruchstücke sich auf der Polymeroberfläche ablagern und diese verunreinigen. Die Polyimide besitzen zwar eine hohe chemische Resistenz, sind aber schwierig zu handhaben, da sie in herkömmlichen organischen Lösungsmitteln unlöslich sind und nur in Form ihrer noch löslichen Vorstufen zu Folien und Überzügen verarbeitet werden können. Die Eigenfarbe dieser Polymermaterialien ist zudem problematisch bei der Verwendung in optischen Bauteilen.

Es bestand daher die Notwendigkeit ein Verfahren zur Erzeugung von Mikrostrukturen in Polymeren zu entwickeln, das die Verwendung eines XeCl-Excimer Lasers erlaubt und bei dem möglichst transparente, gut handhabbare und im technischen Maßstab herstellbare Polymermaterialien als Substrate verwendet werden können. Diese Aufgabe konnte gelöst werden durch den Einsatz von z.B. Polyarylaten oder Polyestercarbonaten oder Blends aus Polyarylaten und Polycarbonaten, die eine bestimmte Struktureinheit innerhalb der Polymerhauptkette und eine hohe Wärmeformbeständigkeit bei gleichzeitiger Transparenz und sehr guten Verarbeitungsmöglichkeiten besitzen. Die für die jeweilige Anwendung erwünschten Polymereigenschaften lassen sich dabei durch die geeignete Wahl von Co-Monomeren in einem breitem Eigenschaftsspektrum variieren.

Polycarbonate und/oder polycarbonathaltige Polymerblends zur Verwendung in der Mikrosystemtechnik sind zwar in der Patentanmeldung DE 4308329 beschrieben, das dort beanspruchte Verfahren verwendet allerdings wesentlich hochenergetischere Röntgenstrahlen zur Strukturierung der Polymeren. Außerdem müssen Entwicklermedien zum Herauslösen der bestrahlten Bereiche verwendet werden. Daß eine direkte Strukturierbarkeit von Polycarbonaten und/oder polycarbonathaltigen Polymerblends, ohne Verwendung eines Entwicklers, bereits mit Laserlicht im mittleren UV-Bereich oberhalb 300 nm erzielt werden kann, war daher überraschend.

Die entstandenen Mikrostrukturen zeigen eine sehr geringe Oberflächenrauhigkeit, hohe Maßgenauigkeit und scharfe Kantenstrukturen, ohne daß die aus anderen Verfahren bekannten Maßnahmen zur Abführung der gebildeten Polymerbruchstücke (z.B. Polyimid-Strukturierung mit nachfolgender Ozon-Behandlung der Polymeroberfläche J-04356387) von der Substratoberfläche nötig sind.

Gegenstand der Erfindung ist ein Verfahren zur Erzeugung von Mikröstrukturen in polymeren Substraten enthaltend mindestens 5 Gew.-% eines aromatischen oder teilaromatischen Polykondensates, wie z.B. Polyurethane, Polyarylate, Copolyester, Polyestercarbonate oder Blends aus diesen Polykondensaten und anderen Thermoplasten, durch Bestrahlung mit Licht, insbesondere eines UV-Lasers, mit einer Wellenlänge im Bereich von 260 - 360 nm, bevorzugt eines XeCl-Excimer Lasers mit einer Emissionswellenlänge von 308 nm, unter Abbau des polymeren Substrates in den bestrahlten Bereichen, dadurch gekennzeichnet, daß im Polykondensat oder der Mischung von dem Polykondensat und anderen Thermoplasten von 5 bis 100 Mol-% Struktureinheiten der Formel (I) 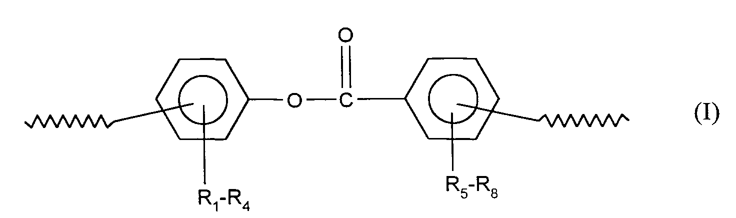 enthält, wobei
- R₁ - R₈: unabhängig voneinander H, Halogen, gegebenenfalls verzweigtes C₁-C₁₈-Alkyl oder -Oxyalkyl, gegebenenfalls substituiertes C₅-C₁₂- Cycloalkyl, gegebenenfalls substituiertes C₆-C₂₀-Alkaryl oder Aralkyl, bevorzugt H oder Methyl bedeutet.

Der aromatische Ring mit den Substituenten R₁-R₄ kann auch Teil einer Bis-phenoleinheit sein. Der aromatische Ring mit den Substituenten R₅-R₈ kann Teil einer aromatischen Disäure sein. Das Strukturelement der Formel I ist neben weiteren Verknüpfungseinheiten Teil der Polymerkette des Polykondensats.

Struktureinheiten der allgemeinen Formel I können erfindungsgemäß in Polycarbonaten, Polyarylaten, Polyestern, aliphatischen und aromatischen Polyestercarbonaten und Polyurethanen, eingebaut sein oder auch als Polyesterblöcke in die genannten Polymeren einkondensiert sein. Eine andere Ausführungsform verwendet Mischungen dieser die Struktureinheit I enthaltenden Polykondensate mit anderen Polycarbonaten, Polyestern, wie z.B. Poly(cyclohexandimethanolterephthalat) (PCT), aliphatischen Polyestercarbonaten, Polyurethanen, Polyetherketonen und Polyetheretherketonen auf Basis von anderen Bisphenolen oder deren Mischungen.

Als Dihydroxy-Komponenten zur Herstellung der Polykondensate können aliphatische, aromatische oder/und auch gemischt aliphatisch/aromatische Dihydroxyverbindungen oder auch beliebige Mischungen dieser Substanzen eingesetzt werden. Ebenso möglich ist die Verwendung von Substanzen, die sowohl eine aromatische Carbonsäureeinheit sowie deren Carbonsäure-Derivate, als auch eine phenolische Funktion besitzen.

Besonders geeignete Dihydroxyverbindungen sind:
- Hydrochinon
- Resorcin
- Dihydroxydiphenyle
- Bis-(hydroxyphenyl)alkane
- Bis-(hydroxyphenyl)cycloalkane
- Bis-(hydroxyphenyl)sulfide
- Bis-(hydroxyphenyl)ketone
- Bis-(hydroxyphenyl)ether
- Bis-(hydroxyphenyl)sulfoxide
- α,α'-Bis-(hydroxyphenyl)-diisopropylbenzole
sowie deren kernalkylierte und/oder kernhalogenierte Verbindungen.

Besonders bevorzugte Bisphenole sind:
- 2,2-Bis-(4-hydroxyphenyl)-propan
- 1,1-Bis-(4-hydroxyphenyl)-cyclohexan
- 1,1-Bis-(4-hydroxyphenyl)-3,3,5-trimethylcyclohexan
- 1,1-Bis-(4-hydroxyphenyl)-1-phenylethan
- 9,9-Bis-(4-hydroxyphenyl)-fluoren
- Bis-(4-hydroxyphenyl)-diphenylmethan

Monomere, über die die Struktureinheit I in die Polykondensate eingeführt werden kann, sind z.B. aromatische Dicarbonsäuren oder Derivate aromatischer Dicarbonsäuren, bevorzugt Ester oder Säurechloride, wobei eventuell auch zusätzlich andere Polymerbausteine, wie aliphatische Dicarbonsäuren und/oder deren Derivate, Derivate der Kohlensäure, wie z.B. Phosgen, sowie Diole mit aromätischen und aliphatischen bzw. ausschließlich aliphatischen Hydroxy-Funktionen zugesetzt werden können. Geeignete aromatische Dicarbonsäuren sind:
- Benzoldicarbonsäuren, wie Terephthalsäure, Isophthalsäure, Phthalsäure und deren ringsubstituierte Derivate sowie Carbonsäure-Derivate dieser Verbindungen wie z.B. Carbonsäurehalogenide oder Carbonsäureester
- Biphenyldicarbonsäuren und deren ringsubstituierte Derivate sowie Carbonsäure-Derivate dieser Verbindungen
- Naphthalindicarbonsäuren und deren ringsubstituierte Derivate sowie Carbonsäure-Derivate dieser Verbindungen
- Pyridindicarbonsäuren und deren ringsubstituierte Derivate sowie Carbonsäure-Derivate dieser Verbindungen
- Dicarbonsäuren nach der allgemeinen Formel II oder deren Säurederivate, bevorzugt deren Ester oder Säurechloride, 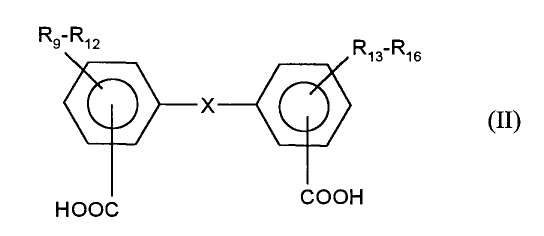
wobei
die Carboxyleinheiten an den Phenylringen unabhängig voneinander die o-, m-, oder p-Position zum verknüpfenden Substituenten X einnehmen,
R₉ - R₁₆ unabhängig voneinander H, Halogen, gegebenenfalls verzweigtes C₁-C₁₈-Alkyl oder -Oxyalkyl, gegebenenfalls substituiertes C₅-C₁₂-Cycloalkyl, gegebenenfalls substituiertes C₆-C₂₀-Alkaryl oder -Aralkyl, bevorzugt jedoch H oder Methyl bedeutet,
X für eine chemische Einfachbindung, O, S, SO, SO₂, CO, sowie eine Alkylidengruppe -C(R₉, R₁₀), mit den unter R₁-R₈ genannten Bedeutungen für R₉ und R₁₀, Cyclohexyl, Methylcyclohexyl, H₃C-C-Phenyl, 3,5,5-Trimethylcyclohexyl steht.

Zur Herstellung der Polykondensate können auch Mischungen zweier oder mehrerer dieser aromatischen Dicarbonsäuren oder deren Derivate in beliebiger Zusammensetzung verwendet werden, z.B. ein Gemisch bestehend aus gleichen Anteilen Terephthalsäure und Isophthalsäure, bzw. der Säurechloride oder Ester dieser Verbindungen.

Des weiteren kann in den Polykondensaten der Anteil an aromatischen Dicarbonsäureester-Einheiten durch Zugabe nicht-aromatischer Dicarbonsäuren oder deren Derivate verringert werden. Andere Dicarbonsäureeinheiten können dabei sein:
- Carbonatspendende Derivate der Kohlensäure wie z.B. Phosgen, Triphosgen, oder Ester der Kohlensäure, wie z.B. Diphenylcarbonat
- Oxalsäure oder deren Derivate
- aliphatische Dicarbonsäuren oder Dicarbonsäurederivate der C₁ - C₂₂-Kohlenwasserstoffreihe, d.h. von Propandisäure bis Tetracosandisäure sowie deren Kohlenwasserstoffketten-substituierte Derivate
- aliphatische Dicarbonsäuren mit einem oder mehreren Heteroatomen, wie z.B. O, S oder NH-Funktionen, innerhalb der Kohlenwasserstoffkette, deren Homologe sowie Carbonsäure-Derivate dieser Verbindungen
- aliphatische Dicarbonsäuren mit einem oder mehreren Aromaten oder Heteroaromaten innerhalb der Kohlenwasserstoffkette, deren Homologe sowie Carbonsäure-Derivate dieser Verbindungen.

Besonders bevorzugt ist die Verwendung von Phosgen oder Diphenylcarbonat zur Herstellung von z.B. aromatischen Polyestercarbonaten.

Anstelle der Verwendung von Estern aus Bishydroxyverbindungen und aromatischen Dicarbonsäuren kann die erfindungsgemäß erforderliche aromatische Esterfunktion im Polykondensat auch durch Einsatz von aromatischen Carbonsäuren, die im Molekül eine OH-Funktion, gebunden an ein aromatisches System, tragen, oder deren Derivate aufgebaut werden. Beispiele für derartige Carbonsäuren sind im einzelnen:
- p-, m-, oder o-Hydroxybenzoesäure und deren ringsubstituierte Derivate
- 4-Hydroxy-4'-diphenylcarbonsäure,
- 4-Hydroxy-4'-diphenylethercarbonsäure,
- 4-Hydroxy-4'-benzophenoncarbonsäure,
- 4-Hydroxy-4'-diphenylsulfidcarbonsäure
- die isomeren Hydroxynaphthoesäuren und deren ringsubstituierte Derivate.

Die aromatische Esterfunktion kann auch anteilig durch Zusatz von trifunktionellen aromatischen Carbonsäuren oder deren Derivate sowie durch Verwendung von Verbindungen mit drei phenolischen Funktionen unter Ausbildung von verzweigten Polymeren erzeugt werden. Ebenso ist der Einsatz von trifunktionellen aliphatischen Carbonsäuren oder deren Derivate sowie von gemischt-trifunktionellen Substanzen (mit sowohl Hydroxy- als auch Carbonsäurefunktionen) als Verzweigermoleküle je nach Anwendung der Polymeren oder der Polymerblends möglich. Geeignete Verzweiger sind z.B.:
- Trimesinsäure
- Cyanurchlorid
- 2,4-Dihydroxybenzoesäure
- 1,3,5-Tris-(4-hydroxyphenyl)-benzol
- 1,1,1-Tris-(4-hydroxyphenyl)-ethan
- Tris-(4-hydroxyphenyl)-methan
- α,α',α''-Tris-(4-hydroxyphenyl)-1,3,5-triisopropylbenzol

Die beschriebenen Polykondensate oder Blends verschiedener Polykondensate können auch Stabilisatoren, Entformungsmittel oder andere gängige Additive und Hilfsmittel bei der Verarbeitung und der Anwendung von Polymeren enthalten.

Eine hohe Wärmeformbeständigkeit des Polykondensates begünstigt die Anwendung des erfindungsgemäßen Verfahrens. Bevorzugt sollte die Glastemperatur des eingesetzten Polykondensates oberhalb 100°C liegen, insbesondere oberhalb 140°C. Für den Einsatz in der Mikrooptik ist der Einsatz transparenter polymerer Substrate üblich. Zum Einsatz in der Mikromechanik können auch nicht-transparente Polymere oder Polymermischungen eingesetzt werden.

Die Herstellung der Polykondensate ist grundsätzlich bekannt und kann z.B. nach dem Zweiphasengrenzflächenverfahren oder nach dem Schmelzeumesterungsverfahren, bzw. anderen Polymerisationsverfahren in Lösung oder in Substanz erfolgen.

Die für das erfindungsgemäße Verfahren in Frage kommenden Lichtquellen emittieren Licht im Bereich von 260 bis 360 nm. Dazu können z.B. auch Excimer-Lichtquellen im kontinuierlichen Betrieb verwendet werden. Im Hinblick auf kurze Bearbeitungszeiten sind aber insbesondere Laser geeignet, wie z.B. frequenzvervielfachte NdYAG-Laser, Stickstofflaser, Farbstofflaser, Argonionen-Laser oder Excimer-Laser. Als Laserlichtquellen werden bevorzugt Edelgas/Halogenid-Excimer Laser (XeCl) eingesetzt. Vorteilhaft sind Lasersysteme mit hohen Repetitionsraten (Wiederholfrequenzen der Laserlichtauskopplung), um zu kurzen Bearbeitungszeiten der Polymermaterialien zu gelangen. Solche Lasersysteme sind für industrielle Anwendungen allgemein verfügbar und werden daher nicht weiter beschrieben.

Zur Durchführung des erfindungsgemäßen Verfahrens zur Mikrostrukturierung nach einer bevorzugten Variante, kann das Substrat, z.B. eine Folie oder eine Platte, bestehend aus den oben beschriebenen polymeren Verbindungen, auf einem in x-, bzw. y-Richtung beweglichen Schiebetisch befestigt werden. Die Folie oder Platte wird dann, gegebenenfalls über ein optisches System, mit einem in z-Richtung (vertikal) verlaufenden fokussierten Laserstrahl bestrahlt. Der Schiebetisch wird so bewegt, daß in der transparenten Folie die gewünschte Mikrostruktur eingebracht wird. Eine andere Möglichkeit zur Durchführung des Verfahrens besteht darin, durch z.B. eine Maske mit der gewünschten. Struktur hindurch die Polymerfolie zu beleuchten und dabei die Mikrostruktur in der Polymeroberfläche zu erzeugen. Dabei kann man zwei Verfahren verwenden: erstens einen stark aufgeweiteten Laserstrahl, der die gesamte Maske ausleuchtet, oder zweitens einen spaltförmigen Laserstrahl, der in der Breite die Maske abdeckt, aber über die Länge der Maske mit Hilfe eines beweglichen Spiegels fortbewegt wird.

Ebenso wie die Bearbeitung von Platten oder Folien als polymerem Substrat ist auch die Verarbeitung von Blöcken nach dem Prozeß des "rapid prototyping" möglich.

Die mikrostrukturierten Polymeren können eingesetzt werden in Anwendungen wie der Mikroelektronik und der Mikrooptik, z.B. für Mikrolinsen, Mikrogittern oder - Prismen zur Herstellung von Mikrosystemen wie Mikrokameras oder Mikrospektrometern, oder zur optischen Datenverarbeitung. Weitere Einsatzgebiete sind die Erzeugung von mikromechanischen Bauteilen für Mikromotoren oder pneumatischen Komponenten und Gleitlagern, Mikrosteckern zur Verbindung optischer Datenüberträger wie z.B. Glasfasern, oder der Einsatz in der Mikrosensorik, z.B. zur Messung von Beschleunigung, Durchfluß und Ultraschall. Darüber hinaus können mit diesem Verfahren mikrostrukturierte Oberflächen und Membranen produziert werden, die in der Energiespeicherung (Sonnenkollektoren) oder in der Energieerzeugung eingesetzt werden (Mini-Brennstoffzellen). Ein weiteres Einsatzgebiet ist das genannte "rapid prototyping", bei dem mittels Computer konstruierte Bauteile mit Hilfe von Lasern durch computergesteuerte Bearbeitung von lichtempfindlichen Materialien als dreidimensionale Prototypen hergestellt werden.

Weitere bevorzugte Ausführungsformen der Erfindung sind den abhängigen Ansprüchen zu entnehmen.

Die folgenden Beispiele sollen die Erfindung erläutern, ohne sie auf die aufgeführten Beispiele einzuschränken. Zur weiteren Erläuterung, insbesondere der technischen Vorteile des erfindungsgemäßen Verfahrens, dienen auch die Figuren.

Es zeigen hierbei:
- Fig. 1: Ein Diagramm eines Oberflächenprofils erzeugt in Makrolon 2808 nach 1 bis 15 Laserpulsen
- Fig. 2: Ein Diagramm eines Oberflächenprofils erzeugt in APE 30 nach 1 bis 15 Laserpulsen
- Fig. 3: Rasterelektronenmikroskopische Aufnahme eines Mikromechanik-Bauteils bestehend aus einem Blend von 10 Gew.-% APE 100 und 90 Gew.-% Makrolon 2808, hergestellt nach dem erfindungsgemäßen Verfahren.

Die Strukturierung der verschiedenen Folien erfolgte bei 308 nm mittels eines XeCl-Excimer Lasers der Fa. Lambda Physics. Die Laser-Pulsrate betrug 20 Hz, bei einer Pulsdauer von 20 ns.

### Beispiel 1

Exemplarisch für die erfindungsgemäß beanspruchten polymeren Substrate wurden folgende Verbindungen auf ihre Ablationseigenschaften bei 308 nm hin geprüft.
"APE 100"
Ein Polyester aus Terephthalsäure-/Isophthalsäuredichlorid (1:1) und 2,2-Bis-(4-hydroxyphenyl)-propan (Bisphenol A), (aromatischer Polyester),
"APE 30 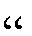
Polyestercarbonat mit Terephthal-/Isophthalsäureeinheiten (z.B. 30 mol-% Terephthalsäure/Isophthalsäuredichlorid 1:1).

### Als Vergleichsbeispiele:

Makrolon 2808, (Bayer AG), rel. Lösungsviskosität γᵣₑₗ = 1,28, gemessen in Dichlormethan.
Polycarbonat aus Phosgen und Bisphenol A, kommerziell erhältlicher Typ
Lexan SP®, (GE Plastics)
ein aliphatisches Polyestercarbonat aus Phosgen, Bisphenol A und ca 12 % Dodecandisäure, ein kommerziell erhältlicher Typ.

Die Tabelle 1 zeigt die Ergebnisse verschiedener Ablationsversuche. Aufgeführt sind die Energiedichten der Laserpulse sowie die erhaltenen Abtragungen in Mikrometern nach der entsprechenden Anzahl an Laserpulsen. Während die Polyestercarbonate und das Polyarylat auch bei geringen Laser-Energiedichten eine Abtragung zeigen, sind bei Polycarbonat und bei dem aliphatischen Polyestercarbonat erst eine größere Anzahl von Laserpulsen notwendig, bis eine Ablation stattfindet.

**Tab. 1**

| Abtragungen des Polymermaterials in Mikrometern nach Laserpulsen mit der angegebenen Energiedichte | | | | | | |
|---|---|---|---|---|---|---|
| Probe | Energiedichte | 1 Puls | 5 Pulse | 10 Pulse | 15 Pulse | Abtragsrate pro Puls |
| | (J/cm²) | (µm) | (µm) | (µm) | (µm) | (µm)/Puls |
| APE 30 | 8,25 | -1,84 | -12,7 | -16 | -24,1 | 1,613 |
| | 4,02 | -1,37 | -8,65 | -10,7 | -16,6 | 1,104 |
| | 2,1 | -1 | -6,23 | -7,55 | -11,5 | 0,784 |
| | 1,01 | -0,57 | -3,75 | -4,82 | -7,09 | 0,484 |
| | 0,53 | -0,11 | -0,62 | -0,84 | -1,74 | 0,086 |
| APE 50 | 8,25 | -1,71 | -12,2 | -15,3 | -22,8 | 1,535 |
| | 4,02 | -1,32 | -7,71 | -10,2 | -14,9 | 1,006 |
| | 2,1 | -0,86 | -6,04 | -7,41 | -10,8 | 0,75 |
| | 1,01 | -0,62 | -3,43 | -4,7 | -6,91 | 0,473 |
| | 0,53 | -0,23 | -1,28 | -1,84 | -2,21 | 0,156 |
| APE 100 | 8,25 | -1,57 | -11,9 | -14,5 | -20,8 | 1,416 |
| | 4,02 | -1,12 | -7,7 | -9,84 | -14,5 | 0,953 |
| | 2,1 | 0,92 | -5,9 | -6,6 | -10,5 | 0,691 |
| | 1,01 | -0,57 | -3,45 | -4,08 | -6 | 0,421 |
| | 0,53 | -0,29 | -1,68 | -1,98 | -2,67 | 0,216 |
| M 2808 | 8,25 | n | -9,21 | -12,2 | -24 | 1,234 |
| | 4,02 | n | -1,45 | -5,22 | -12,2 | 0,574 |
| | 2,1 | n | n | n | n | |
| | 1,01 | n | n | n | n | |
| | 0,53 | n | n | n | n | |
| Lexan SP | 8,25 | n | -8,41 | -16,1 | -28 | 1,651 |
| | 4,02 | n | -3,65 | -6,78 | -13 | 0,722 |
| | 2,1 | n | n | n | -4,85 | |
| | 1,01 | n | n | n | n | |
| | 0,53 | n | n | n | n | |
| "n" bedeutet, daß keine Polymerabtragung gemessen werden konnte. | | | | | | |

### Beispiel 2

Polymermischungen aus Polyarylat APE 100 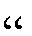 und BPA-Polycarbonat, Anteile Polyarylat: 1, 5, 10 und 20 Gewichts-%) im Vergleich zu den entsprechenden Copolymeren mit entsprechenden Mol-% Anteilen der aromatischen Estereinheit an der Gesamtzahl der Wiederholungseinheiten des Polyestercarbonates. Aus dem Beispiel ist zu entnehmen, daß erst ab einer Mindestkonzentration an aromatischen Polyestereinheiten (als Copolymer oder als Blend) auch bei geringeren Laser-Energiedichten eine Ablation stattfindet. Diese Konzentrationsschwelle liegt bei 5 Mol-%.

**Tab. 2**

| Abtragungen von Blends aus APE 100 und Polycarbonat im Vergleich zu den entsprechenden Polyestercarbonaten in Mikrometern, nach Laserpulsen mit der angegebenen Energiedichte. Die erforderliche Konzentration an aromatischen Estereinheiten für eine genügend gute Ablation liegt dabei bei 5 Mol-%. | | | | | | |
|---|---|---|---|---|---|---|
| Probe | Energiedichte | 1 Puls | 5 Pulse | 10 Pulse | 15 Pulse | Abtragsrate |
| | (J/cm²) | (µm) | (µm) | (µm) | (µm) | (µm)/Puls |
| APE001 | 18,45 | 9,35 | -10,2 | -24,5 | -35,6 | 2,165 |
| | 5,96 | 10,1 | -1,1 | -12,2 | -19,1 | 1,129 |
| | 3,18 | 0,144 | -0,987 | -5,7 | -9,06 | 0,55 |
| | 1,52 | n | n | n | -2,86 | |
| APE005 | 18,45 | 0,5 | -11,4 | -22,9 | -33,6 | 2,249 |
| | 5,96 | 1,48 | -6,55 | -12,2 | -17,8 | 1,176 |
| | 3,18 | 1,95 | -4,28 | -8,93 | -12,6 | 0,84 |
| | 1,52 | 1,1 | -2,04 | -4,7 | -7,16 | 0,443 |
| APE010 | 18,45 | -1,86 | -11,5 | -22,6 | -33,8 | 2,259 |
| | 5,96 | -1,17 | -6,09 | -11,7 | -17 | 1,172 |
| | 3,18 | 0,693 | -4,36 | -8,17 | -12,2 | 0,822 |
| | 1,52 | -0,624 | -2,75 | -5,25 | -7,78 | 0,536 |
| APE020 | 18,45 | -2,5 | -11,6 | -23 | -34,9 | 2,321 |
| | 5,96 | -1,54 | -6,26 | -12,1 | -18,1 | 1,234 |
| | 3,18 | -1,13 | -4,51 | -8,62 | -12,9 | 0,887 |
| | 1,52 | -0,953 | -3,23 | -5,87 | -8,72 | 0,619 |
| Comp. 1 % APE | 18,45 | 10,6 | -8,4 | -24,3 | -40,3 | 2,285 |
| | 5,96 | 7,84 | n | -9,69 | -17,7 | 1,086 |
| | 3,18 | n | n | -3,88 | n | |
| | 1,52 | n | n | n | -1,75 | |
| Comp. 5 % APE | 18,45 | -0,232 | -10,3 | -20,1 | -30 | 1,949 |
| | 5,96 | | -5,39 | -10,7 | -16,1 | 1,076 |
| | 3,18 | 0,227 | -4,48 | -8,04 | -11,7 | 0,81 |
| | 1,52 | 0,796 | -3,41 | -6,22 | -8,88 | 0,6 |
| Comp. 10 % APE | 18,45 | -1,87 | -10,5 | -20,4 | -30,6 | 2,055 |
| | 5,96 | -0,869 | -5,43 | -10,8 | -16,4 | 1,094 |
| | 3,18 | -0,621 | -4,15 | -7,82 | -11,7 | 0,794 |
| | 1,52 | -0,559 | -3,24 | -6,1 | -8,89 | 0,625 |
| Comp. 20 % APE | 18,45 | -2,18 | -10,5 | -21,1 | -30,6 | 2,092 |
| | 5,96 | -1,29 | -5,6 | -11 | -16,2 | 1,109 |
| | 3,18 | -0,852 | -4,06 | -7,7 | -11,5 | 0,787 |
| | 1,52 | -0,646 | -3,09 | -5,79 | -8,57 | 0,596 |

### Beispiel 3

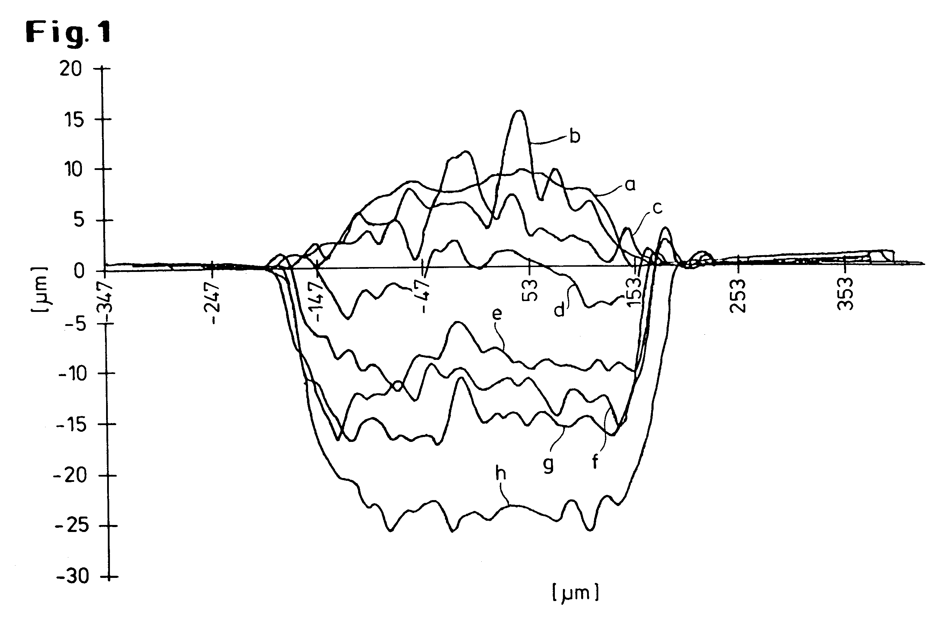

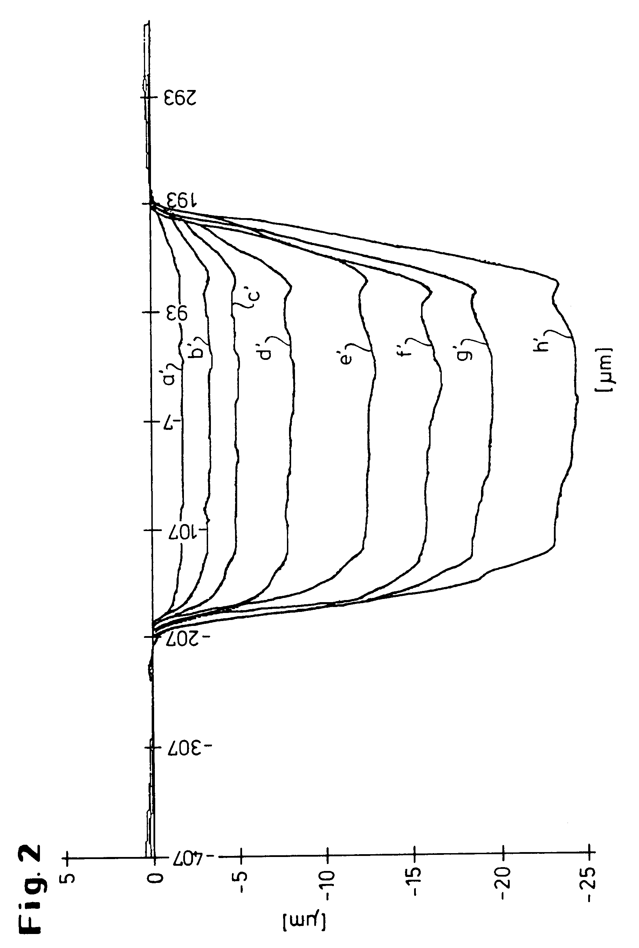

Die Abtragungsprofile (gemessen durch Abtasten der Oberflächen mit einem Profilometer) für ein Polycarbonat Makrolon 2808 als Vergleichsbeispiel für ein Polymer ohne die erfindungsgemäß notwendigen aromatischen Estereinheiten und exemplarisch für ein Polyestercarbonat APE 30 mit einem Anteil von 30 Mol-% der aromatischen Estereinheiten wurden durch Bestrahlung, wie in Beispiel 1, mit 1 bis 15 Pulsen erzeugt. In den Figuren 1 und 2 ist das mittels eines Profilometers gemessene Oberflächenprofil aufgetragen nach Einwirkung der nachstehenden Anzahl an Laserpulsen der Energiedichte 8,25 J/cm². Während bei Polycarbonat (Fig. 1) ein undefiniertes Aufschäumen und anschließend ein ebenso undefiniertes Abtragen der Polymeroberfläche zu erkennen ist, ist bei dem Polyestercarbonat mit 30 Mol-% Anteil an aromatischen Polyestereinheiten, APE 30, eine exakte Strukturierung zu beobachten (Fig. 2).

Es sind jeweils Profile für folgende Pulszahlen wiedergegeben:

| Kurve: | |
|---|---|
| a bzw. a' | 1 Puls |
| b bzw. b' | 2 Pulse |
| c bzw. c' | 3 Pulse |
| d bzw. d' | 5 Pulse |
| e bzw. e' | 8 Pulse |
| f bzw. f' | 10 Pulse |
| g bzw. g' | 12 Pulse |
| h bzw. h' | 15 Pulse |

### Beispiel 4

Die hochauflösende Strukturierung wurde exemplarisch an einer Mischung aus einem Polyarylat APE 100 und BPA-Polycarbonat Makrolon 2808, Anteil Polyarylat: 10 Gewichts-% vorgenommen. Die Eignung des Verfahrens z.B. zur

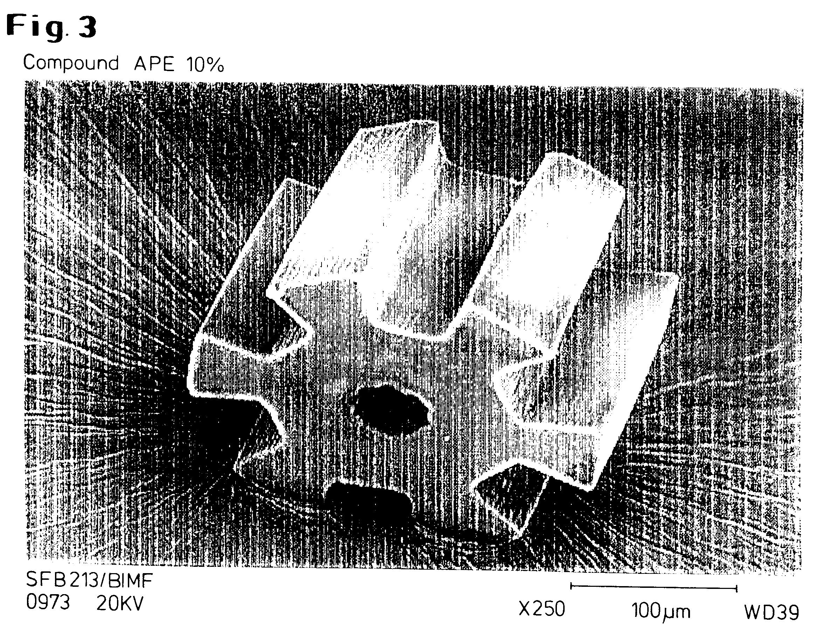

Herstellung von Bauteilen für die Mikromechanik (Zahnrad) ist offenkundig (siehe Fig. 3).

Das erzeugte Bauteil zeigt saubere gerade Schnittkanten. Die Erzeugungsbedingungen waren wie folgt:

Das Zahnrad wurde hergestellt im "schreibenden" Verfahren, bei dem eine auf einem Computer erzeugte Struktur rechnergesteuert auf eine Polymerfolie übertragen wird. Die Laserenergie des verwendeten XeCl-Excimer-Lasers betrug 9 J/cm² pro Puls.

## Patentansprüche

1. Verfahren zur Erzeugung von Mikrostrukturen in polymeren Substraten enthaltend mindestens 5 Gew.-% eines aromatischen oder teilaromatischen Polykondensates durch Bestrahlung mit Licht einer Wellenlänge im Bereich von 260 bis 360 nm unter Abbau des polymeren Substrates in den bestrahlten Bereichen, dadurch gekennzeichnet, daß im Polykondensat oder der Mischung von dem Polykondensat und anderen Thermoplasten von 5 bis 100 Mol-% Struktureinheiten der Formel I 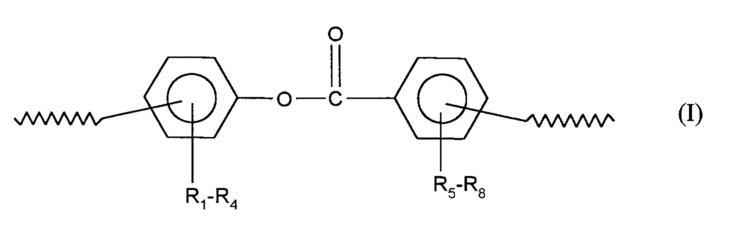 enthält, wobei
R₁- R₈ unabhängig voneinander H, Halogen, gegebenenfalls verzweigtes C₁ -C₁₈-Alkyl oder -Oxyalkyl, gegebenenfalls substituiertes C₅-C₁₂-Cycloalkyl, gegebenenfalls substituiertes C₆-C₂₀-Alkaryl oder -Aralkyl, bevorzugt H oder Methyl bedeutet.

2. Verfahren nach Anspruch 1, dadurch gekennzeichnet, daß das Polykondensat ausgewählt ist aus der Reihe Polyurethan, Polyarylat, (Co-)Polyester, Polycarbonat und Polyestercarbonat.

3. Verfahren nach einem der Ansprüche 1 bis 2, dadurch gekennzeichnet, daß als Lichtquelle ein im Wellenlängenbereich von 260 bis 360 nm emittierender Excimer-Strahler oder Laser im kontinuierlichen oder diskontinuierlichen Betrieb verwendet wird.

4. Verfahren nach einem der Ansprüche 1 bis 3, dadurch gekennzeichnet, daß als Lichtquelle insbesondere ein gepulster Excimerlaser verwendet wird

5. Verfahren nach den Ansprüchen 1 bis 4, dadurch gekennzeichnet, daß den Polykondensaten oder den Gemischen, bestehend aus zweien oder mehreren Polykondensaten, gegebenenfalls Additive wie Thermostabilisatoren, UV-Stabilisatoren, Flammschutzmittel, Gleithilfsmittel, Antistatika oder Entformungsmittel zugesetzt werden können, in Mengen von 0-5 Gew.-% bezogen auf den Anteil des oder der Polykondensate.

6. Verfahren nach den Ansprüchen 1 bis 5, dadurch gekennzeichnet, daß die Polykondensate oder ihre Mischungen transparent sind.

7. Verfahren nach den Ansprüchen 1 bis 6, dadurch gekennzeichnet, daß als Laserlichtquelle ein XeCl-Excimer Laser verwendet wird.

8. Verfahren nach den Ansprüchen 1 bis 7, dadurch gekennzeichnet, daß gepulstes Laserlicht verwendet wird, das eine Pulswiederholungsrate von 0,1 bis 5000 Pulsen, bevorzugt 5 bis 1000 Pulse, besonders bevorzugt 10 bis 500 Pulse pro Sekunde besitzt, wobei die Pulsdauer eine Femtosekunde bis eine Millisekunde, bevorzugt eine Nanosekunde bis fünfzig Nanosekunden, besonders bevorzugt 10 bis 30 Nanosekunden beträgt.

9. Verfahren nach den Ansprüchen 1 bis 8, dadurch gekennzeichnet, daß die Energiedichte des auf das Substrat einwirkenden Lichtstrahls, insbesondere des Laserpulses von 0,01 bis 500, bevorzugt von 0,5 bis 50, besonders bevorzugt 1 bis 20 J/cm² auf der Oberfläche des Substrates beträgt.

10. Verfahren nach den Ansprüchen 1 bis 9, dadurch gekennzeichnet, daß die Strukturierung der Polykondensate oder Polymermischungen direkt durch die Führung der fokussierten eingesetzten Lichtquelle oder unter Zuhilfenahme einer Abbildungsmaske erfolgt.

11. Verwendung der mikrostrukturierten Substrate aus dem Verfahren nach einem der Ansprüche 1 bis 10 in der Mikrosystemtechnik, in der Mikroelektronik, der Mikrooptik, sowie der Mikromechanik, zur Erzeugung optischer Datenspeicher bzw. zur Datenspeicherung und/oder Datenübertragung.
